(19) Europäisches Patentamt / European Patent Office / Office européen des brevets

(11) **EP 4 579 869 A1**

(12) **EUROPEAN PATENT APPLICATION**
published in accordance with Art. 153(4) EPC

(43) Date of publication:
**02.07.2025 Bulletin 2025/27**

(21) Application number: **23907693.8**

(22) Date of filing: **19.12.2023**

(51) International Patent Classification (IPC):
*H01M 10/42* (2006.01)     *G01N 27/82* (2006.01)

(52) Cooperative Patent Classification (CPC):
**G01N 27/82; H01M 10/42**

(86) International application number:
**PCT/KR2023/021005**

(87) International publication number:
**WO 2024/136410 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.12.2022 KR 20220180417**

(71) Applicant: **LG Energy Solution, Ltd.
Seoul 07335 (KR)**

(72) Inventors:
• **LEE, Jong Cheol
Daejeon 34122 (KR)**
• **KWON, Bong Keun
Daejeon 34122 (KR)**
• **LIM, Jaehwan
Daejeon 34122 (KR)**
• **KIM, Jinwoong
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS FOR DETECTING DEFECTS OF BATTERY CELL AND METHOD FOR DETECTING DEFECTS OF BATTERY CELL**

(57)     An apparatus for detecting defects of a battery cell according to an embodiment of the present disclosure includes: a magnetic field measuring section that measures the magnetic field generated by the current flowing through the battery cell; a support section that supports the magnetic field measuring section; and a mounting section on which the battery cell is placed, wherein the magnetic field measuring section comprises a first measuring member that scans one side of the battery cell, a second measuring member that scans the other side of the battery cell opposite to the one side, and a third measuring member that is coupled between the first measuring member and the second measuring member, and wherein the first measuring member, the second measuring member, and the third measuring member are integrated.

[FIG. 2]

EP 4 579 869 A1

# Description

## [TECHNICAL FIELD]

Cross Citation with Related Application(s)

This application claims the benefit of Korean Patent Application No. 10-2022-0180417 filed on December 21, 2022 with the Korean Intellectual Property Office, the disclosure of which is incorporated herein by reference in its entirety.

The present disclosure relates to an apparatus for detecting defects of a battery cell and a method for detecting defects of a battery cell, and more specifically, to an apparatus for detecting defects of a battery cell that detects an abnormal current in a battery cell, and a defective battery cell, and/or detects a defective portion by applying a 3D magnetic field scanning sensor and determining an abnormal current, and a detecting method therefor.

## [BACKGROUND]

X-ray CT, which is a conventional non-contact, non-destructive analysis method for battery cells, requires a long analysis time, thus making real-time analysis of various defect causes impossible. Further, visual detection such as X-ray CT is not effective for verifying battery cell deterioration or defects (lithium deposition, tab breakage, etc.), and thus disassembly analysis is required. In order to solve defects of such X-ray CT analysis, studies have been conducted to analyze defects through visualization of the current distribution inside the battery cell, however, in the measurement of induced magnetic fields through MRI guidance, it was impossible for electromagnetic waves to penetrate battery cells, and it was also difficult to obtain high resolution due to the ferromagnetic material contained in the battery cells.

Therefore, it is necessary to develop diagnostic technology and testing methods for cell deterioration and defects through non-destructive analysis. As a way to detect such changes, research has recently been conducted to introduce technology using magnetic field imaging (MFI) to detect defects through changes in the magnetic field formed during charging and discharging of battery cells.

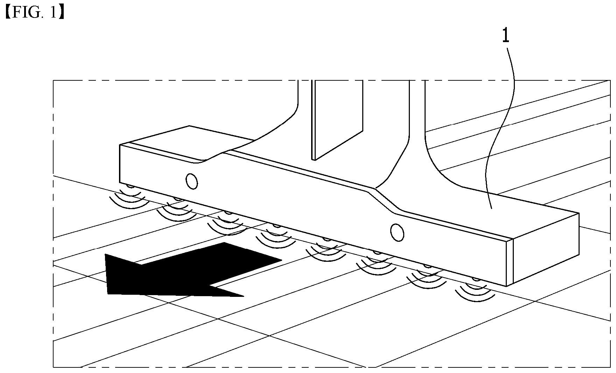

FIG. 1 shows an apparatus 1 for detecting defects of a battery cell according to the prior art. Imaging of current flow through MFI measurement is performed on the cross section of the battery cell. In other words, the magnetic field is measured while flowing current through the battery cell, and then the current value is calculated using the current-magnetic field relationship (Biot-Savart Law) and imaged. However, according to this prior art, the measurement unit exists only on the top surface, so that only 2D cross-sectional measurement of the battery cell is possible. Further, only magnetic field detection on the surface of the battery cell (i.e., the surface facing the magnetic field detection apparatus) is possible, and detection of magnetic fields on the side surface or bottom surface of the battery cell is impossible. The apparatus for detecting defects of a battery cell according to the prior art performs magnetic field measurements limited to a 2D cross section and only the surface current is observed, and so it is limited in detecting disconnection/foreign substances inside the cell.

## [DETAILED DESCRIPTION OF THE INVENTION]

### [Technical Problem]

It is an object of the present disclosure to provide an apparatus for detecting defects of a battery cell and a method for detecting defects of a battery cell. It is another object of the present disclosure to provide a technique for sensing abnormal currents in a battery cell particularly by implementing in 3D when applying a magnetic field imaging technique. It is a further object of the present disclosure to detect defects within a battery cell more effectively, that is, more quickly and more accurately, using a more efficient method for calculating abnormal current in a battery cell and determining an abnormal current.

However, the technical problems to be solved by embodiments of the present disclosure are not limited to the above-described problems, and can be variously expanded within the scope of the technical idea included in the present disclosure.

### [Technical Solution]

According to one embodiment of the present disclosure, there is provided an apparatus for detecting defects of a battery cell, comprising: a magnetic field measuring section that measures the magnetic field generated by the current flowing through the battery cell; a support section that supports the magnetic field measuring section; and a mounting section on which the battery cell is placed, wherein the magnetic field measuring section comprises a first measuring member that scans one side of the battery cell, a second measuring member that scans the other side of the battery cell opposite to the one side, and a third measuring member that is coupled between the first measuring member and the second measuring member, and wherein the first measuring member, the second measuring member, and the third measuring member are integrated.

The magnetic field measuring section may include the first measuring member, the second measuring member, and the third measuring member, and simultaneously scan the top surface, bottom surface, and side surface of the battery cell.

One third measuring member is provided, and may connect one end of the first measuring member and one end of the second measuring member.

Two third measuring members are provided, wherein one may connect one end of the first measuring member and one end of the second measuring member, and the other may connect the other end of the first measuring member and the other end of the second measuring member.

The mounting section is a support member having a plate shape on which the battery cell is placed, and includes the support member disposed in the air at a predetermined distance upward from the bottom surface, and the second measuring member may be disposed below the support member.

The support member may have a low magnetic permeability ($\mu$) so that the influence of the support member on the magnetic field scanning of the second measuring member is minimized.

The apparatus for detecting defects of a battery cell may further comprise: a processing unit that converts measured magnetic field data to determine the presence or absence of defects in the battery cell or a defective portion of the battery cell.

Each of the first measuring member, the second measuring member, and the third measuring member has a bar or rod shape, and the magnetic field measuring section may move in the longitudinal direction of the battery cell, thereby scanning the battery cell.

The first measuring member, the second measuring member, and the third measuring member may each individually generate magnetic field data.

A three-dimensional magnetic field vector value may be generated from magnetic field data individually generated from each of the first measuring member, the second measuring member, and the third measuring member.

The magnetic field data may be a magnetic field image(MFI).

The type of defects detected above may include at least one of: a folded portion of the electrode plate of the battery cell, a disconnection portion of the electrode plate, a portion where the electrode active material is unevenly applied to the coated portion of the electrode plate, a disconnection portion of the electrode lead or electrode tab of the battery cell, and a portion where the stacked electrode plates are misaligned.

According to another embodiment of the present disclosure, there is provided a method for detecting defects of a battery cell, the method comprising the steps of: receiving magnetic field data measured by a magnetic field measuring section; deriving a three-dimensional magnetic field vector value for each of a plurality of sub-regions of the battery cell from the received magnetic field data; converting the derived magnetic field vector value into a three-dimensional induced current vector value; determining whether the induced current value corresponds to a current value in a normal range by comparing the induced current vector value with a predetermined current vector threshold; and detecting the presence or absence of defects in the battery cell or a defective portion of the battery cell.

The step of converting the derived magnetic field vector value into an induced current vector value may comprise multiplying the induced current vector value by a correction coefficient.

The step of determining whether the induced current value corresponds to a current value in a normal range may comprise determining that that there is a current abnormality in the battery cell if the induced current vector value is larger than a predetermined upper limit current vector threshold or if the induced current vector value is smaller than a predetermined lower limit current vector threshold.

**[Advantageous Effects]**

According to the present disclosure, when applying magnetic field imaging technology to detect defects of a battery cell, it is especially possible to inspect battery cells more precisely from multiple perspectives, thereby making it possible to ensure reliability in the quality of the produced battery cells.

In addition, highly reliable preliminary inspection is possible at the battery cell level, and therefore, when inspecting a battery module or battery pack, it is also possible to solve the inefficiency problem of discarding the entire battery module or battery pack due to one defective cell.

Effects obtainable from the present disclosure are not limited to the effects mentioned above, and additional other effects not mentioned herein will be clearly understood from the description of the appended claims by those skilled in the art.

**[BRIEF DESCRIPTION OF THE DRAWINGS]**

FIG. 1 shows an apparatus for detecting defects of a battery cell according to the prior art.

FIG. 2 is a perspective view which schematically shows an apparatus for detecting defects of a battery cell according to an embodiment of the present disclosure.

FIG. 3 is a front view of an apparatus for detecting defects of a battery cell of FIG. 2.

FIG. 4 is an example of a magnetic field image generated by the MFI method.

FIG. 5 shows an example of the final current vector value *I*.

FIG. 6 shows an example of a type of defects in a battery cell.

**[DETAILED DESCRIPTION OF THE EMBODIMENTS]**

Hereinafter, embodiments disclosed in the present specification will be described in detail with reference to the accompanying drawings, however, identical or similar elements are assigned identical or similar reference numerals, and a redundant description thereof will be omitted.

The suffixes "member" and/or "part" of elements used in the description below are assigned or used only in consideration of the ease of description of the specification, and the suffixes themselves do not have meanings or roles distinguished from each other. In addition, a term such as "... member", "... part" described in the specification means a unit for performing at least one function or operation, which can be embodied by hardware, by software, or by a combination of hardware and software.

In the following description of the present disclosure, a detailed description of known functions and configurations incorporated herein will be omitted if it is determined that it may make the subject matter of the present disclosure unclear. In addition, the accompanying drawings are only for easy understanding of the embodiments disclosed in the present specification, however, the technical idea disclosed herein is not limited by the accompanying drawings and should be construed as including all changes, equivalents and substitutes included in the spirit and scope of the present disclosure

In this specification, terms such as "include" or "have" are intended to designate that the features, numbers, steps, operations, components, parts, or combinations thereof described in the specification exist, but it should be understood that this does not preclude in advance the possibility of the existence or addition of one or more other features, numbers, steps, operations, components, parts, or combinations thereof.

Below, an apparatus 100 for detecting defects of a battery cell according to an embodiment of the present disclosure will be described.

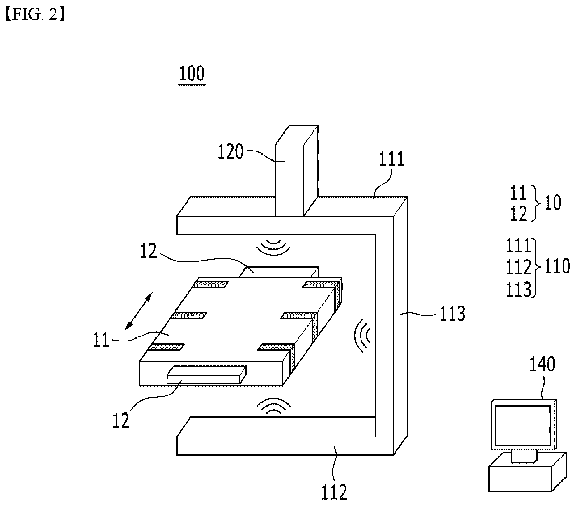

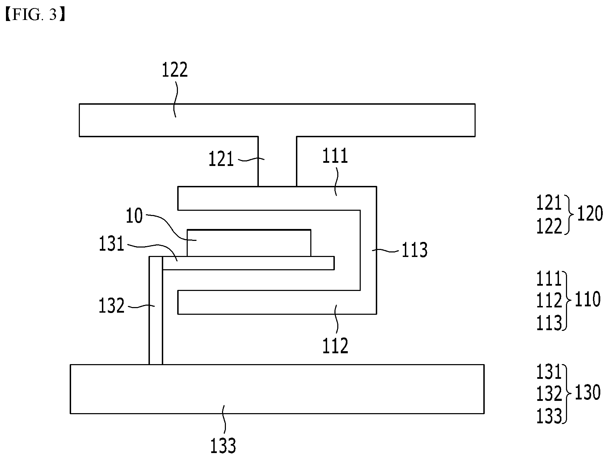

FIG. 2 is a perspective view which schematically shows an apparatus 100 for detecting defects of a battery cell according to an embodiment of the present disclosure. FIG. 3 is a front view of an apparatus 100 for detecting defects of a battery cell of FIG. 2.

The apparatus 100 for detecting defects of a battery cell according to an embodiment of the present disclosure broadly includes: a magnetic field measuring section 110, a support section 120 to which the magnetic field measuring section 110 is connected to fix and support the magnetic field measuring section 110, a mounting section 130 on which the battery cell 10 is placed, and a processing unit 140 and/or a storage unit 140.

The magnetic field measuring section 110 is disposed near the battery cell 10 and spaced away from the battery cell 10 by a predetermined distance. A current is applied to the battery cell 10, the current flows through the battery cell 10 between a positive electrode lead 12 and a negative lead 12 of the battery cell 10, and a magnetic field is induced therefrom. The magnetic field measuring section 110 measures the magnetic field induced from the current flowing through the battery cell 10. The main body 11 of the battery cell 10 may be scanned, and the main body 11, the positive electrode lead 12 and the negative electrode lead 12, and the positive electrode tab and the negative electrode tab may also be scanned as a whole.

In the apparatus 100 for detecting defects of a battery cell according to an embodiment of the present disclosure, the magnetic field measuring section 110 can scan the battery cell 10 in three dimensions at once. The magnetic field measuring section 110 may have, for example, a ⌐ shape or a square shape. More specifically, the magnetic field measuring section 110 includes a first measuring member 111 that scans one side of the battery cell 10, a second measuring member 112 that scans the other side opposite to one side of the battery cell 10, and one or two third measuring members 113 coupled between the first measuring member 111 and the second measuring member 112.

The first measuring member 111 and the second measuring member 112 may be arranged in parallel to each other. Further, one third measuring member 113 may be coupled between one end of the first measuring member 111 and one end of the second measuring member 112. Thereby, the magnetic field measuring section 110 has a ⌐ shape. Alternatively, two third measuring members 113 may be respectively coupled between one end of the first measuring member 111 and one end of the second measuring member 112, and coupled between the other end of the first measuring member 111 and the other end of the second measuring member 112. Thereby, the magnetic field measuring section 110 may have a square shape.

Each of the first measuring member 111, the second measuring member 112, and the third measuring member 113 includes a scanner unit that scans a magnetic field on a surface facing the battery cell 10.

The first measuring member 111, the second measuring member 112, and the third measuring member 113 are integrated into one. More specifically, the first measuring member 111, the second measuring member 112, and the third measuring member 113 may be formed integrally, or may be fabricated separately and then coupled together. Further, each of the first measuring member 111, the second measuring member 112 and the third measuring member 113 may have a bar or rod shape. Alternatively, each of the first measuring member 111, the second measuring member 112 and the third measuring member 113 may have a plate shape. In the former case, the magnetic field measuring section 110 may scan the magnetic field of the battery cell 10 while moving along the longitudinal direction of the battery cell 10. In the latter case, if each of the first measuring member 111, the second measuring member 112 and the third measuring member 113 can cover the battery cell 10, the magnetic field of the battery cell 10 can be scanned at once without movement of the magnetic field measuring section 110.

For example, the first measuring member 111 may scan the top surface of the battery cell 10, and the second measuring member 112 may scan the bottom surface of the battery cell 10. Further, the third measuring member 113 may scan both sides or one side of the battery cell 10. However, the present disclosure is not limited to those set forth above, and when scanning with the battery cell 10 upright, various modifications and changes are possible, for example, the first measuring member 111 and the second measuring member 112 can each scan both sides of the battery cell 10, and the third measuring member 113 can scan the top surface or bottom surface of the battery cell 10.

In addition, the first measuring member 111, the second measuring member 112 and the third measuring member 113 simultaneously scan the battery cell 10, wherein the first measuring member 111, the second measuring member 112 and the third measuring member 113 each individually generate magnetic field data from the battery cells 10. In regard to magnetic field data, refer to those described later.

A support section 120 is connected and fixed to the magnetic field measuring section 110 to support the magnetic field measuring section 110. In an exemplary embodiment of FIG. 3, the case where the support section 120 is connected to the first measuring member 111 is illustrated, but the present disclosure is not limited thereto, and the support section 120 may be connected to at least one of the first measuring member 111, the second measuring member 112 and the third measuring member 113.

When the magnetic field measuring section 110 scans the battery cell 10 while moving, the support section 120 may further include a driving member. The magnetic field measuring section 110 may scan the battery cell 10 while moving in the longitudinal direction by the driving member included in the support section 120.

The battery cell 10 is mounted on the mounting section 130 including the support member 131. The mounting section 130 broadly includes a support member 131, a pillar member 132, and a table 133. The battery cell 10 is placed on the plate-shaped support member 131. The support member 131 may be located in the air at a predetermined distance upward from the bottom surface (e.g., table 133) by a pillar member 132. The second measuring member 112 of the magnetic field measuring section 110 is disposed on the bottom surface of the support member 131. Thereby, not only the first measuring member 111 may be disposed on one side of the battery cell 10, but also the second measuring member 112 opposite thereto may be disposed on the other side opposite to the one side of the battery cell 10.

Meanwhile, a support member 131 is located between the second measuring member 112 of the magnetic field measuring section 110 and the battery cell 10. The support member 131 has a low magnetic permeability ($\mu$) so that the support member 131 has no influence on the magnetic field scanning of the second measuring member 112, or the influence is minimized.

Data containing the magnetic field value of the battery cell 10 measured by scanning in the magnetic field measuring section 110 (hereinafter referred to as "magnetic field data") is transmitted to a processing unit 140 and/or a storage unit 140 by wire or wirelessly. The processing unit 140 and/or the storage unit 140 may be provided separately, or may be integrated into one device. The processing unit 140 and/or the storage unit 140 may be, for example, a computer, a notebook, or various control devices applicable to the environment in which the invention is implemented and corresponding process.

Magnetic field data scanned by the magnetic field measuring section 110 may be transmitted by wire through a data transmission line (not shown) provided on the support section 120 connected to the magnetic field measuring section 110. Alternatively, the magnetic field measuring section 110 or the support section 120 connected thereto may include a separate transceiver (not shown) to transmit the magnetic field data scanned by the magnetic field measuring section 110 wirelessly in real time (e.g., by repeating the method of scanning a certain portion of the battery cell 10 and transmitting magnetic field data) or after scanning is completed as a whole.

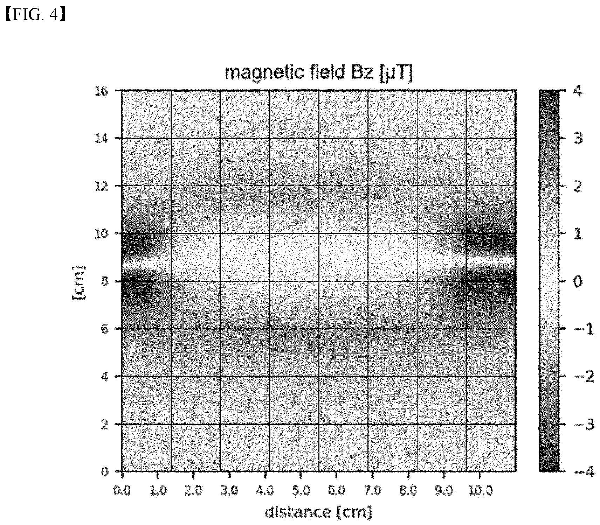

Further, the magnetic field data transmitted from the magnetic field measuring section 110 may be the magnetic field value itself, or may be a magnetic field image generated by the MFI method (e.g., see FIG. 4). Alternatively, the magnetic field data transmitted from the magnetic field measuring section 110 is the magnetic field value itself, and the processing unit 140 may generate a magnetic field image using the MFI method. The unit of magnetic field value is T by way of example.

In regard to the processing unit 140 and/or the storage unit 140, refer to a method for detecting defects of a battery cell to be described later.

Next, a method for detecting defects of a battery cell according to an embodiment of the present disclosure will be described. The method for detecting defects of a battery cell is performed in the processing unit 140 of the apparatus 100 for detecting defects of a battery cell. In addition, data can be transmitted/received, and stored in the storage unit 140. That is, the processing unit 140 may perform a method for detecting defects of a battery cell in conjunction with the storage unit 140.

First, a step (S110) of receiving magnetic field data from the magnetic field measuring section 110 in the processing unit 140 and/or the storage unit 140 is performed. In regard to magnetic field data transmission from the magnetic field measuring section 110, refer to the portion set forth above.

Further, a step (S120) of deriving magnetic field vector values for each of the plurality of sub-regions of the battery cell from the received magnetic field data is performed. The processing unit 140 generates three-dimensional magnetic field vector values $B=(B_x, B_y, B_z)$ from the magnetic field data received from the magnetic field measuring section 110. The three-dimensional magnetic field vector values are magnetic field vector values at the x-axis position, y-axis position, and z-axis position of the battery cell 10. The region of the battery cell 10 can be divided into a plurality of sub-regions in three dimensions, and the magnetic field vector value B for each region can be generated. In the apparatus 100 for detecting defects of a battery cell of the present disclosure, since the magnetic field measuring section 110 scans the battery cell 10 in three dimensions, such a three-dimensional magnetic field vector value B can be generated from the magnetic field data received from the magnetic field measuring section 110.

In regard to the generation of the magnetic field vector value $B$, for example, each magnetic field image generated from the first measuring member 111, the second measuring member 112 and the third measuring member 113 of the magnetic field measuring section 110 is divided into a grid shape as shown in FIG. 4, and then a three-dimensional vector value B can be derived from the corresponding magnetic field image value for each region.

Further, for example, a three-dimensional magnetic field vector value B can be generated by a method of weighting, summing and correcting from magnetic field data received from the first measuring member 111, the second measuring member 112 and the third measuring member 113 of the magnetic field measuring section 110. For example, since the first measuring member 111 and the second measuring member 112 are located on both surfaces of the battery cell 10 opposite to each other, a three-dimensional magnetic field vector value $B$ can be derived by combining them.

However, the present disclosure is not limited to those set forth above, and any method that can generate a three-dimensional magnetic field vector value $B = (B_x, B_y, B_z)$ is sufficient.

Next, a step(S130) of converting the derived magnetic field vector value into induced current data is performed. Since it is calculated from the magnetic field vector value, the induced current data becomes the induced current vector value (hereinafter referred to as "current vector value").

Each of the three-dimensional magnetic field vector values $B = (B_x, B_y, B_z)$ at the x-axis, y-axis, and z-axis positions of the battery cell 10 is converted into the current vector value $I_0 = (I_{0x}, I_{0y}, I_{0z})$. That is, the converted current value means the current value flowing at the corresponding x-axis, y-axis, and z-axis positions of the battery cell 10. The process of converting a magnetic field into a current follows the Biot-Savart Law of the following Mathematical Equation 1.

[Mathematical Equation 1]

$$B = \frac{\mu_0}{4\pi} \int \frac{I d\vec{l} \times \hat{r}}{r^2} dr$$

wherein, $B$ is the magnetic field, $I$ is the current, $\mu_0$ is the permeability in free space, and r is the diameter (i.e., the distance from the corresponding region of the battery cell 10 to the magnetic field measuring section 110).

In addition, when converting the corresponding magnetic field into current, the final current vector value $I$ can be derived by multiplying the correction coefficient ($\alpha$). This is a coefficient for correcting an error between the current value that actually flows in the relevant region of the battery cell 10 and the current value that is induced from the magnetic field due to the relevant device or surrounding environment, etc. If correction is not necessary, the correction coefficient can be set to $\alpha = 1$.

[Mathematical Equation 2]

$$I = (I_x, I_y, I_z) = \alpha I_0$$

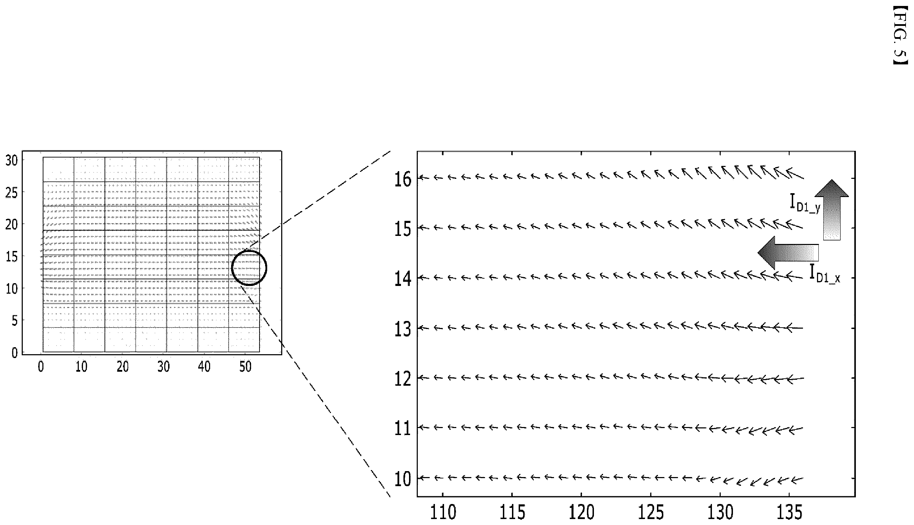

FIG. 5 shows an example of the final current vector value $I$.

In addition, the above process is performed from the magnetic field data transmitted from the first measuring member 111, the second measuring member 112 and the third measuring member 113, respectively, to derive $I_{D1}$, $I_{D2}$, $I_{D3}$ respectively. The $I_{D1}$, $I_{D2}$, $I_{D3}$ mean currents derived from the magnetic field data of the first measuring member 111, the second measuring member 112 and the third measuring member 113, respectively, in that order.

Next, a step (S140) of determining whether the induced current value corresponds to a current value in the normal range is performed. By comparing the derived induced current vector value with the current vector threshold, the presence or absence of an abnormal current can be determined.

The presence or absence of an abnormal current is determined by comparing respective $I_{D1}$, $I_{D2}$, $I_{D3}$ with the current threshold value $I_{TH}$ of a normal cell. That is, if it exceeds the current threshold $I_{TH}$ of a normal cell, it can be determined as a current abnormality. In addition, the current threshold of the normal cell may be set to an upper current threshold $I_{TH\text{-}high}$ and/or a lower current threshold $I_{TH\text{-}low}$, respectively. In this case, if $I$ is larger than the upper current threshold $I_{TH\text{-}high}$ or smaller than the lower current threshold $I_{TH\text{-}low}$, it can be determined as current abnormality. Further, respective $I_{D1}$, $I_{D2}$, $I_{D3}$ may be set by changing the current threshold $I_{TH}$.

Next, a step (S150) of detecting defects in the battery cell 10 is performed. For example, if it is determined in step (S140) that it is an abnormal current, it may be determined that the corresponding battery cell 10 is defective. In addition, for example, since the battery cell 10 is divided into a plurality of sub-regions and a current vector value $I$ is derived for each sub-region, the sub-region where an abnormal current is detected can be determined to be a defective region.

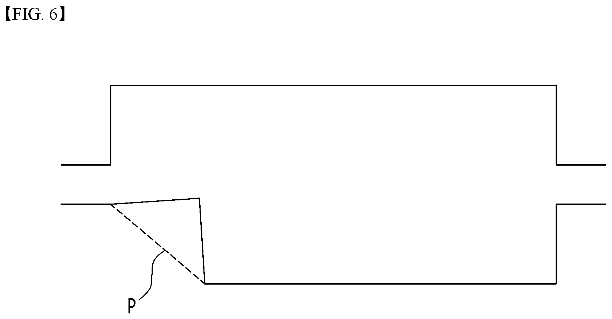

For reference, the defects of the battery cell 10 may include, for example, folding of the electrode plate 11a or disconnection of the electrode plate 11a (e.g., perforation or tearing, etc.), defective application of electrode active material to the coated portion of the electrode plate 11a, disconnection of electrode tabs or electrode leads, or misalignment of a plurality of electrode plates stacked inside the battery cell 10. FIG. 6 shows, as an example, a case where the electrode plate is folded at the folded portion P.

When detecting defects of the battery cell 10 using the apparatus 100 for detecting defects of a battery cell and the method for detecting defects of a battery cell according to the present disclosure, it is possible to quickly determine the presence or absence of defects of the battery cell 10 and/or the coupling portion of the battery cell 10 as compared to the prior art. At the same time, it is possible to more accurately determine the presence or absence of defects of the battery cell 10 and/or the coupling portion of the battery cell 10. Thereby, reliability of the quality of the produced battery cells can be secured.

Although the invention has been described in detail above with reference to preferred embodiments thereof, it will be appreciated by those skilled in the art that the scope of the present disclosure is not limited thereto, and various modifications and improvements can be made in these embodiments without departing from the principles and sprit of the invention, the scope of which is defined in the appended claims and their equivalents.

[Description of Reference Numerals]

    10: battery cell
    11: main body
    12: electrode lead
    100: apparatus for detecting defects of a battery cell
    110: magnetic field measuring section
    111: first measuring member
    112: second measuring member
    113: third measuring member
    120: support section
    130: mounting section
    131: support member
    132: pillar member
    133: table
    140: processing unit/storage unit

**Claims**

1. An apparatus for detecting defects of a battery cell, comprising:

   a magnetic field measuring section that measures the magnetic field generated by the current flowing through the battery cell;
   a support section that supports the magnetic field measuring section; and
   a mounting section on which the battery cell is placed,
   wherein the magnetic field measuring section comprises a first measuring member that scans one side of the battery cell, a second measuring member that scans the other side of the battery cell opposite to the one side, and a third measuring member that is coupled between the first measuring member and the second measuring member, and
   wherein the first measuring member, the second measuring member and the third measuring member are integrated.

2. The apparatus for detecting defects of a battery cell according to claim 1, wherein:
   the magnetic field measuring section includes the first measuring member, the second measuring member, and the third measuring member, and simultaneously scans the top surface, bottom surface, and side surface of the battery cell.

3. The apparatus for detecting defects of a battery cell according to claim 1, wherein:
   one third measuring member is provided, and connects one end of the first measuring member and one end of the second measuring member.

4. The apparatus for detecting defects of a battery cell according to claim 1, wherein:
   two third measuring members are provided, wherein one connects one end of the first measuring member and one end of the second measuring member, and the other connects the other end of the first measuring member and the other end of the second measuring member.

5. The apparatus for detecting defects of a battery cell according to claim 1, wherein:

   the mounting section is a support member having a plate shape on which the battery cell is placed, and includes the support member disposed in the air at a predetermined distance upward from a bottom surface, and
   the second measuring member is disposed below the support member.

6. The apparatus for detecting defects of a battery cell according to claim 1, wherein:
the support member has a low magnetic permeability ($\mu$) so that the influence of the support member on the magnetic field scanning of the second measuring member is minimized.

7. The apparatus for detecting defects of a battery cell according to claim 1,
further comprising a processing unit that converts measured magnetic field data to determine the presence or absence of defects in the battery cell or a defective portion of the battery cell.

8. The apparatus for detecting defects of a battery cell according to claim 1, wherein:

   each of the first measuring member, the second measuring member and the third measuring member has a bar or rod shape, and
   the magnetic field measuring section moves in the longitudinal direction of the battery cell, thereby scanning the battery cell.

9. The apparatus for detecting defects of a battery cell according to claim 1, wherein:
the first measuring member, the second measuring member and the third measuring member each individually generate magnetic field data.

10. The apparatus for detecting defects of a battery cell according to claim 9, wherein:
a three-dimensional magnetic field vector value is generated from the magnetic field data individually generated from each of the first measuring member, the second measuring member, and the third measuring member.

11. The apparatus for detecting defects of a battery cell according to claim 1, wherein:
the magnetic field data is a magnetic field image(MFI).

12. The apparatus for detecting defects of a battery cell according to claim 1, wherein:
the type of defects detected above includes at least one of: a folded portion of an electrode plate of the battery cell, a disconnection portion of the electrode plate, a portion where the electrode active material is unevenly applied to the coated portion of the electrode plate, a disconnection portion of an electrode lead or electrode tab of the battery cell, and a portion where the stacked electrode plates are misaligned.

13. A method for detecting defects of a battery cell, the method comprising the steps of:

   receiving magnetic field data measured by a magnetic field measuring section;
   deriving a three-dimensional magnetic field vector value for each of a plurality of sub-regions of the battery cell from the received magnetic field data;
   converting the derived magnetic field vector value into a three-dimensional induced current vector value;
   determining whether the induced current value corresponds to a current value in a normal range by comparing the induced current vector value with a predetermined current vector threshold; and
   detecting the presence or absence of defects in the battery cell or a defective portion of the battery cell.

14. The method for detecting defects of a battery cell according to claim 13, wherein:
the converting the derived magnetic field vector value into an induced current vector value comprises multiplying the induced current vector value by a correction coefficient.

15. The method for detecting defects of a battery cell according to claim 13, wherein:
the determining whether the induced current value corresponds to a current value in a normal range comprises determining that that there is a current abnormality in the battery cell if the induced current vector value is larger than a predetermined upper limit current vector threshold or if the induced current vector value is smaller than a predetermined lower limit current vector threshold.

【FIG. 1】

【FIG. 2】

100

120

111

11
12 } 10

111
112 } 110
113

113

140

12

11

12

112

【FIG. 3】

【FIG. 4】

【FIG. 5】

【FIG. 6】

P

## INTERNATIONAL SEARCH REPORT

| | International application No. |
| --- | --- |
| | **PCT/KR2023/021005** |

| | |
| --- | --- |
| **A. CLASSIFICATION OF SUBJECT MATTER** | |
| **H01M 10/42**(2006.01)i; **G01N 27/82**(2006.01)i | |
| According to International Patent Classification (IPC) or to both national classification and IPC | |

**B. FIELDS SEARCHED**

Minimum documentation searched (classification system followed by classification symbols)

H01M 10/42(2006.01); G01R 31/387(2019.01); G01R 31/392(2019.01); H01M 10/48(2006.01); H01M 50/178(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 자기장 측정부(magnetic field measurement unit), 지지부(support unit), 장착부 (mounting unit), 측정부재(measurement member), 결함(defect)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0099364 A (LG CHEM, LTD.) 24 August 2020 (2020-08-24)<br>See paragraphs [0017]-[0067], claim 1 and figures 4a-4c. | 1-15 |
| A | KR 10-2020-0005290 A (JEONGAN SYSTEM CO., LTD.) 15 January 2020 (2020-01-15)<br>See paragraphs [0037]-[0050] and figures 1-2. | 1-15 |
| A | KR 10-2022-0157634 A (OSUNG HITECH CO., LTD. et al.) 29 November 2022 (2022-11-29)<br>See paragraphs [0034]-[0087] and figures 2-7. | 1-15 |
| A | KR 10-2471145 B1 (CALIFORNIA INSTITUTE OF TECHNOLOGY) 25 November 2022 (2022-11-25)<br>See paragraphs [0064]-[0092] and claim 1. | 1-15 |
| A | KR 10-2023739 B1 (LG CHEM, LTD.) 20 September 2019 (2019-09-20)<br>See paragraphs [0054]-[0079] and figure 3. | 1-15 |

☐ Further documents are listed in the continuation of Box C.  ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **27 March 2024** | **27 March 2024** |

| Name and mailing address of the ISA/KR | Authorized officer |
| --- | --- |
| **Korean Intellectual Property Office**<br>**Government Complex-Daejeon Building 4, 189 Cheongsa-**<br>**ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
| --- |
| **PCT/KR2023/021005** |

| Patent document cited in search report | | | Publication date (day/month/year) | Patent family member(s) | | | Publication date (day/month/year) |
| --- | --- | --- | --- | --- | --- | --- | --- |
| KR | 10-2020-0099364 | A | 24 August 2020 | CN | 113597562 | A | 02 November 2021 |
| | | | | EP | 3901643 | A1 | 27 October 2021 |
| | | | | JP | 2022-507511 | A | 18 January 2022 |
| | | | | KR | 10-2497448 | B1 | 08 February 2023 |
| | | | | US | 11774515 | B2 | 03 October 2023 |
| | | | | US | 2022-0065944 | A1 | 03 March 2022 |
| | | | | WO | 2020-166840 | A1 | 20 August 2020 |
| KR | 10-2020-0005290 | A | 15 January 2020 | KR | 10-2151175 | B1 | 03 September 2020 |
| | | | | WO | 2020-009337 | A1 | 09 January 2020 |
| KR | 10-2022-0157634 | A | 29 November 2022 | None | | | |
| KR | 10-2471145 | B1 | 25 November 2022 | CN | 105229458 | A | 06 January 2016 |
| | | | | CN | 114295984 | A | 08 April 2022 |
| | | | | EP | 2972285 | A1 | 20 January 2016 |
| | | | | EP | 2972285 | A4 | 09 November 2016 |
| | | | | JP | 2016-531271 | A | 06 October 2016 |
| | | | | JP | 2019-132849 | A | 08 August 2019 |
| | | | | JP | 2021-103176 | A | 15 July 2021 |
| | | | | KR | 10-2015-0128749 | A | 18 November 2015 |
| | | | | KR | 10-2020-0100876 | A | 26 August 2020 |
| | | | | KR | 10-2022-0163504 | A | 09 December 2022 |
| | | | | KR | 10-2330200 | B1 | 22 November 2021 |
| | | | | US | 10353012 | B2 | 16 July 2019 |
| | | | | US | 10955483 | B2 | 23 March 2021 |
| | | | | US | 11549993 | B2 | 10 January 2023 |
| | | | | US | 11879946 | B2 | 23 January 2024 |
| | | | | US | 2014-0272500 | A1 | 18 September 2014 |
| | | | | US | 2017-0315178 | A1 | 02 November 2017 |
| | | | | US | 2020-0088802 | A1 | 19 March 2020 |
| | | | | US | 2021-0286010 | A1 | 16 September 2021 |
| | | | | US | 2023-0375631 | A1 | 23 November 2023 |
| | | | | US | 9658292 | B2 | 23 May 2017 |
| | | | | WO | 2014-152650 | A1 | 25 September 2014 |
| KR | 10-2023739 | B1 | 20 September 2019 | CN | 112654866 | A | 13 April 2021 |
| | | | | CN | 112654866 | B | 10 October 2023 |
| | | | | EP | 3835778 | A1 | 16 June 2021 |
| | | | | EP | 3835778 | B1 | 26 April 2023 |
| | | | | JP | 2021-536111 | A | 23 December 2021 |
| | | | | JP | 7134340 | B2 | 09 September 2022 |
| | | | | US | 11761927 | B2 | 19 September 2023 |
| | | | | US | 2022-0034843 | A1 | 03 February 2022 |
| | | | | WO | 2020-213846 | A1 | 22 October 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220180417